# EUROPEAN PATENT SPECIFICATION

(11) **EP 1 758 388 B1**
(45) Date of publication and mention of the grant of the patent: **07.07.2010**
(21) Application number: 06118295.2
(22) Date of filing: 02.08.2006
(51) Int. Cl.: H04N 5/64, G11B 33/14, H05K 5/02, H05K 7/20

(54) **Peripheral skirt intended to be attached underneath the bottom panel of a device, and corresponding device**
Schürze zur Befestigung an der Peripherie unter dem Boden einer Vorrichtung, und entsprechende Vorrichtung
Jupe périphérique destinée à être attachée sous le fond d'un dispositif, et dispositif correspondant

(30) Priority: 23.08.2005 EP 05107720
(43) Date of publication of application: 28.02.2007
(73) Proprietor: Thomson Licensing, 92443 Issy-les-Moulineaux Cedex (FR)
(72) Inventor: Knight, Simon, RCT, CF39 8UA (GB)
(74) Representative: Kohrs, Martin

(56) References cited:
- EP-A- 1 052 884
- EP-A- 1 538 629
- WO-A-02/071820

## Description

The present invention relates to a peripheral skirt intended to be attached underneath the bottom panel of a device, as well as a device comprising such a skirt.

An electronic device, such as for example a set-top box, is a metal or plastic box intended to be placed on a surface such as a rack or a television receiver. The bottom of the metal box is usually not directly in contact with the supporting surface. A number of pads, typically made of a vibration-absorbing material such as rubber or felt, are attached to the bottom panel. This permits to isolate the device from the surface on which it is placed and to stabilize the device.

Certain devices require internal fans in order to cool the numerous electronic components. The fans suck air from the box and expel it through a ventilation grate in order to create appropriate paths for the air flowing through the device. While the noise created by such fans may be acceptable in certain environments, it is less acceptable in a home cinema environment. Other components, such as a hard disk drive also generate noise which may be heard through the ventilation grate.

The invention EP1 052884A from Matsushita Electric Industrial Co, LTD, 15 November 2000, relates to a cooling structure of an electronic appliance, where the heat generated in an heat generating part is exhausted outside of the housing of the electronic appliance by the air passing through a wind tunnel.

It is therefore desirable to reduce the noise perceived by the users of the device.

The present invention concerns an electronic device comprising a bottom panel, and a ventilation hole on the bottom panel, characterized in that it comprises a peripheral skirt attached to the bottom panel, the skirt surrounding the hole, and the skirt comprising an opening on one side of the bottom panel for permitting privileged evacuation of noise from the ventilation hole towards the opening, said side being the side furthest away from the user when the device is in its working environment.

According to an embodiment of the invention, the bottom panel comprises a back side directed away from a user when the device is in functioning conditions, and that the opening is oriented towards the back side.

According to an embodiment of the invention, the peripheral skirt tends to conform to the borders of the bottom panel.

According to an embodiment of the invention, the skirt comprises a molded part and a strip, the molded part comprising a back side and a front side, the back side being fixed to the bottom panel of the device, the strip being fixed to the front side, the molded part being intended to ensure a minimum air flow rate for the device cooling, and the strip being intended to absorb vibrations from the device.

According to an embodiment of the invention, a fan is placed against the ventilation hole within the device for creating an air flow through the opening.

Another object of the invention is a peripheral skirt intended to be attached to a bottom panel of an electronic device comprising a ventilation hole on the bottom panel, characterized in that, when fixed to the device, the skirt surrounds the hole and comprises an opening to one side of the bottom panel for privileged evacuation of noise towards the opening, said side being the side furtherst away from the user when the device is in its working environment.

According to an embodiment of the invention, the peripheral skirt comprises a molded part intended to be fixed to the device and a strip fixed to the molded part, the molded part being intended to create a space of a minimum section when the device is placed on a surface, and the strip being intended to absorb vibrations.

According to an embodiment of the invention, the molded part comprises a groove intended to allow the fastening of the strip.

The invention will be better understood and illustrated by means of the following embodiment, in no way restrictive, and which will be described with reference to the appended figures among which:
- Figure 1 represents a rear view of the peripheral skirt according to one embodiment of the invention;
- Figure 2 represents a front view and a view of each side of the molded part of the peripheral skirt of figure 1;
- Figure 3 represents the section BB indicated in figure 2;
- Figure 4 represents the section DD indicated in figure 2;
- Figure 5 represents a device comprising a peripheral skirt.

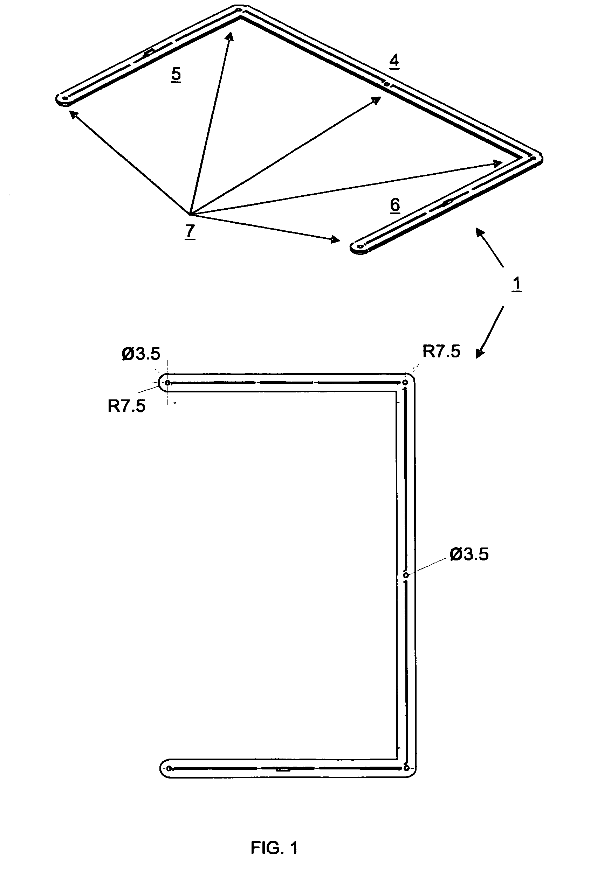

Figure 1 is a view of the rear side of a peripheral skirt 1 that forms a U, or more generally a shape open on one side. It comprises a front branch 4, a right branch 5 and a left branch 6. In the present embodiment, the right branch 5 and the left branch 6 each make a right angle with the front branch 4.

There is a hole 7 at the end of each branch. The end of each side branch is rounded, with a 15 mm diameter circle. The square angle between side branches and front branch is similarly rounded. The center of the circle at the end of each side branch and at each square angle corresponds to the centre of the hole 7. The diameter of each hole 7 is 3.5 mm. There is also a hole 7 in the middle of the front branch 4. The holes are destined to facilitate fixing the skirt to electronic device with the help of screws.

Note that the dimensions are given as an example only: other dimensions may be used.

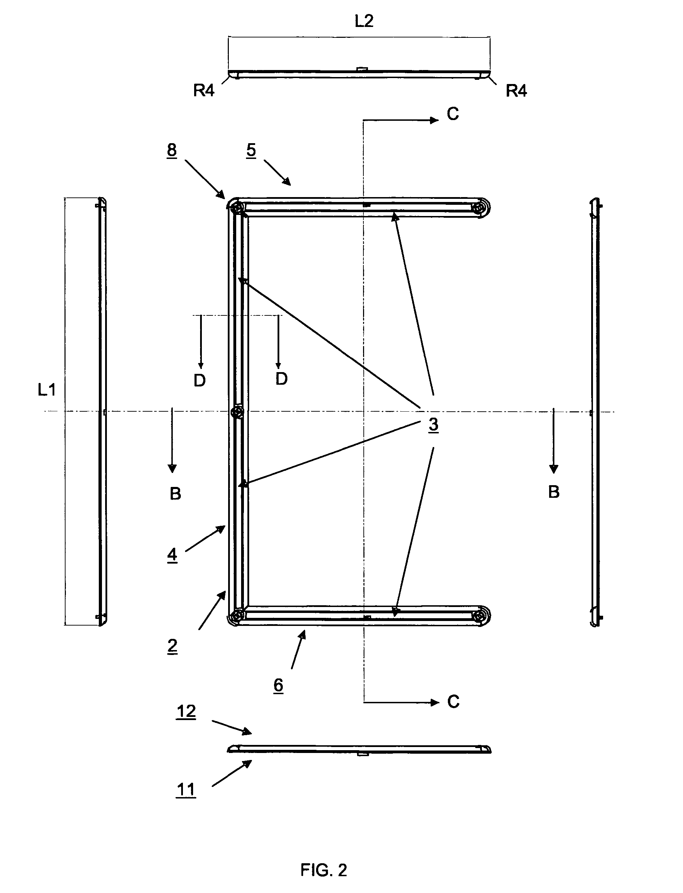

Figure 2 is a front view and a view of each of the sides of the peripheral skirt 1. The peripheral skirt 1 comprises a molded part 2 and four strips 3. It comprises five holes 8 intended to receive fixation screws. The strips 3 are fixed on the molded part 2 between each pair of holes 8, for example using appropriate glue.

Means other than screws for fixing the skirt to the device may also be envisaged by the Man Skilled in the Art: e.g. using glue, resilient plugs added to the skirt and destined to cooperate with appropriate holes of the device, etc...

According to the present embodiment, the front branch 4, the right branch 5 and the left branch 6 are 15 mm wide and 5 mm thick. The front branch length L1 is 340mm. Left and right branches' length L2 is 207 mm.

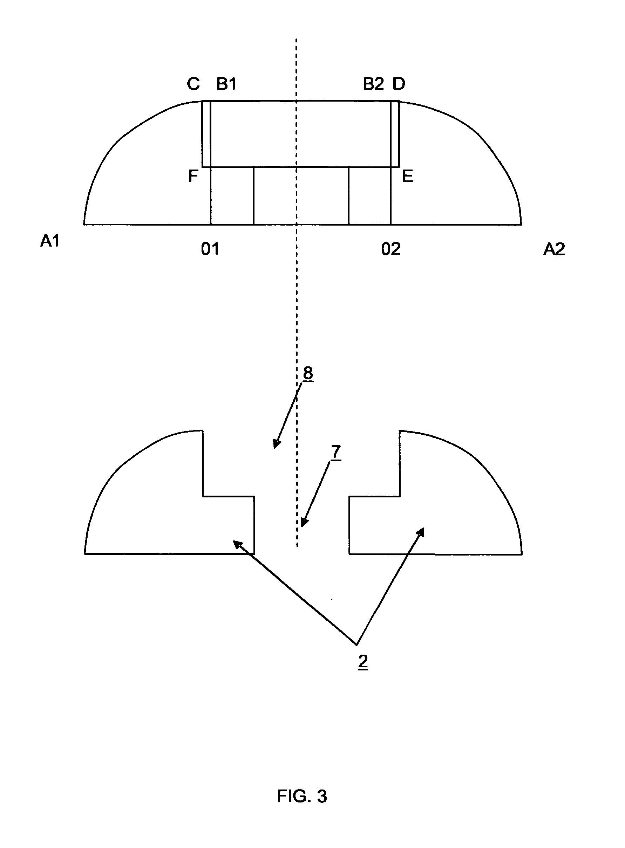

Figure 3 is a view of the section BB of the peripheral skirt represented in figure 2.

The front side 12 of each branch is rounded with a lengthwise groove in the middle. The back side 11 of each branch is flat; when the peripheral skirt is fixed to a device, this allows the back side 11 of the peripheral skirt to be entirely in contact with the device.

It comprises an open section that corresponds to hole 7 and the cavity intended to receive the screw head 8.

The section BB is designed as follows.

It is comprised of a rectangle B1 B2 O2 O1. B1 B2 and O2 O1 are 7 mm. B1 O1 and O2 B2 are 4 mm.

The section BB is also comprised of two quarter circles
- A1O1B1 forms a right angle, and A1, B1 are in the perimeter of the quarter circle centered in O1
- A2O2B2 forms a right angle, and A2, 82 are in the perimeter of a quarter circle centered in 02.

The section BB also comprises an open area that represents a rectangle CDEF, CD being 8 mm long and DE being 2 mm large. The middle of CD is also the middle of B1-B2. DE is the same direction as B1-O1.

Finally the section BB comprises an open area that is 3.5mm large and crosses the middle of the section.

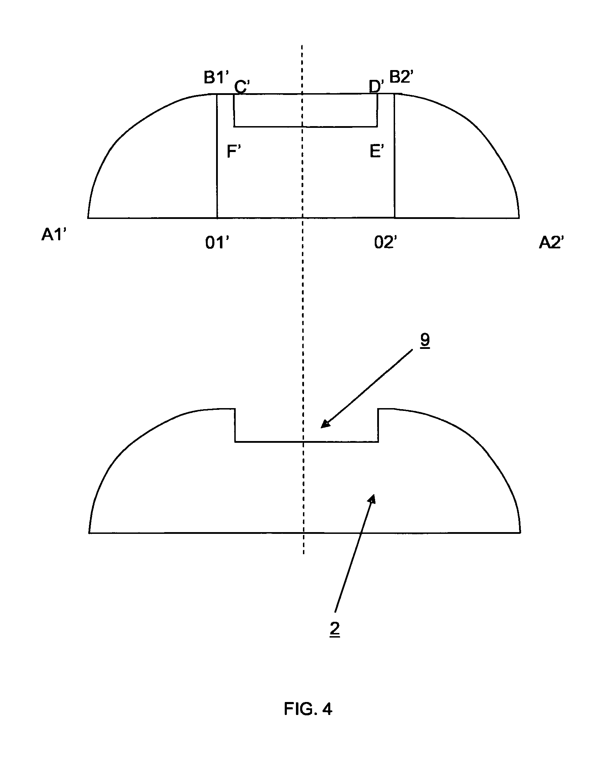

Figure 4 is a view of the section DD of the peripheral skirt represented in figure 2. It comprises an open section that corresponds to the groove 30.

The groove 9 is 1 mm deep and 5 mm wide. The groove 9 of the molded part 2 is intended to receive a strip 3. The strip 3 is glued on the molded part 2 between each screw hole 8 so that it does not cover the screw hole. The strip 3 is 5 mm wide and 2.36 to 3.18 mm thick.

In a variant embodiment, the screw head is low enough compared to the grove as to allow the strip to cover the screw head.

The section BB is designed like the section DD with A1', B1', 01', A2', B2', 02' corresponding to A1, B1, 01, A2, B2, 02 indicated in figure 3.

The difference with the section BB is the absence of a hole 7 in that section, and the absence of the screw head cavity. The open area represented by the rectangle C'D'E'F' has different length than CDEF of figure 3. C'D' is 5 mm long and D'E' is 1 mm large. This corresponds to the groove.

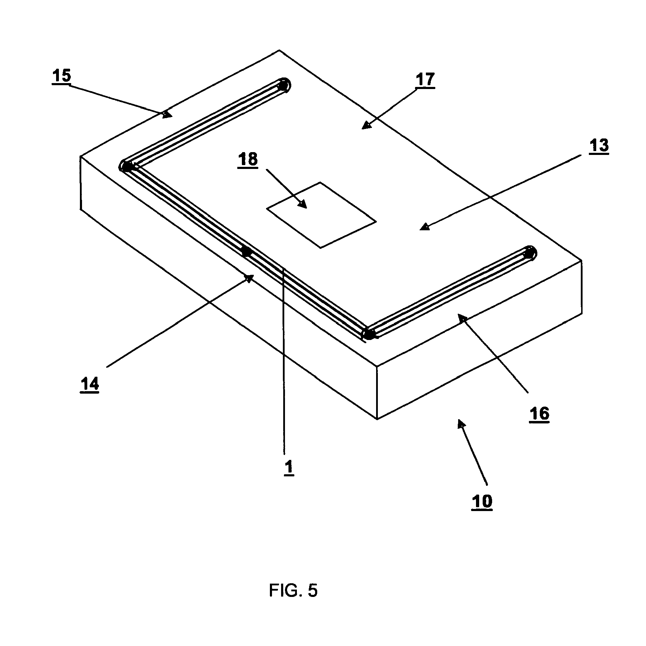

Figures 5 represents a parallelepiped device 10 with a bottom panel 13 comprising a front edge 14, a left side edge 16, a right side edge 15 and a back edge 17.

According to the present embodiment, the device 10 is a set-top box television receiver and comprises a fan hole 18 on the bottom panel 13. It also comprises a peripheral skirt 1, such as previously described, and that is screwed to the bottom panel 13. The peripheral skirt 1 surrounds the fan hole 18. The front branch 4 of the peripheral skirt is fixed to the border front edge 14 of the bottom panel 13. The right 5 and left 6 side branches of the peripheral skirt are respectively fixed to the right 15 and left 16 side edges of the bottom panel 13.

Air and noise are then routed to the open side, which is preferably oriented towards the back panel, away from the user when the device is placed in its working environment. Therefore, as the opening side is the back side 17, the peripheral skirt 1 contributes to the isolation of the front side 14 and the lateral sides 16 and 17 of the device 10 with regard to air flow and noise.

According to the present embodiment, the peripheral skirt is sensibly U shaped. However, it may also have a V shape, horseshoe shape, an arched shaped or a polygonal shape etc..., as long as its shape tends to direct air and/or noise from the ventilation opening into a predetermined direction. Moreover, the peripheral skirt tends to conform to the borders of the bottom panel of the device.

According to the present embodiment, the molded part is preferably manufactured using high impact polystyrene material, noted HIPS. The density value of the HIPS is around 1040 kg/m3. The material is sufficiently rigid and absorbent to reduce vibrations of the device and shocks effects.

The molded part material also ensures a minimum thickness between the bottom panel of the device and the place where it is put, even if a supplementary weight is added on the top of the device. The peripheral skirt is not flattened out under the weight of the device. This ensures then a minimum air flow rate for the device cooling.

According to the present embodiment, the strips 3 are manufactured using high density urethane plastic material. The density value is comprised between 240 and 480 kg/m3. The strip material enhances shock absorption and dampens vibrations.

The described device is a set-top box. It could be any type of device that comprises a bottom panel and requires a peripheral skirt for enhanced stability. It could be any type of device that comprises a bottom panel with a ventilation hole.

## Claims

1. Electronic device (10) comprising a bottom panel (13), and a ventilation hole (18) on said bottom panel (13), **characterized in that** it comprises a peripheral skirt (1) attached to said bottom panel (13), said skirt (1) surrounding said hole (18), said skirt comprising an opening on one side of said bottom panel (13) for permitting privileged evacuation of noise from the ventilation hole towards said opening, said side being the side furthest away from the user when the device is in its working environment.

2. Device (10) according to the preceding claim, **characterized in that** said bottom panel (13) comprises a back side (17) directed away from a user when said device is in functioning conditions, and that said opening is oriented towards said back side (17).

3. Device (10) according to the preceding claims, **characterized in that** said peripheral skirt (1) tends to conform to the borders of said bottom panel (13).

4. Device (10) according to the preceding claims, **characterized in that** said skirt (1) comprises a molded part (2) and a strip (3),
- said molded part (2) comprising a back side (11) and a front side (12),
- said back side (11) being fixed to the bottom panel of said device,
- said strip (3) being fixed to said front side (12),
- said molded part (2) being intended to ensure a minimum air flow rate for the device cooling, and
- said strip (3) being intended to absorb vibrations from said device.

5. Device (10) according to the preceding claims, **characterized in that** a fan is placed against said ventilation hole within the device for creating an air flow through the opening.

6. Peripheral skirt (1) intended to be attached to a bottom panel (13) of an electronic device (10) comprising a ventilation hole (18) on said bottom panel (13), **characterized in that** when fixed to said device (10) said skirt (1) surrounds said hole and comprises an opening to one side of said bottom panel (13) for privileged evacuation of noise towards said opening, said side being the side furthest away from the user when the device is in its working environment.

7. Peripheral skirt (1) according to claim 6, **characterized in that** it comprises a molded part (2) intended to be fixed to said device (1) and a strip (3) fixed to said molded part (2), said molded part (2) being intended to create a space of a minimum section when the device is placed on a surface, and said strip (3) being intended to absorb vibrations.

8. Peripheral skirt (1) according to the preceding claim, **characterized in that** said molded part (2) comprises a groove (9) intended to allow the fastening of said strip (3).

## Patentansprüche

1. Elektronische Vorrichtung (10), die eine Bodenplatte (13) und ein Entlüftungsloch (18) in der Bodenplatte (13) umfasst, **dadurch gekennzeichnet, dass** sie eine an der Bodenplatte (13) befestigte Peripherieschürze (1) umfasst, wobei die Schürze (1) das Loch (18) umgibt, wobei die Schürze auf einer Seite der Bodenplatte (13) eine Öffnung umfasst, um die bevorzugte Abführung von Geräusch aus dem Entlüftungsloch in Richtung der Öffnung zuzulassen, wobei die Seite diejenige Seite ist, die von dem Benutzer am weitesten entfernt ist, wenn die Vorrichtung in ihrer Arbeitsumgebung ist.

2. Vorrichtung (10) nach dem vorhergehenden Anspruch, **dadurch gekennzeichnet, dass** die Bodenplatte (13) eine Rückseite (17) umfasst, die von einem Benutzer weggerichtet ist, wenn die Vorrichtung unter Funktionsbedingungen ist, und dadurch, dass die Öffnung in Richtung der Rückseite (17) orientiert ist.

3. Vorrichtung (10) nach den vorhergehenden Ansprüchen, **dadurch gekennzeichnet, dass** die Peripherieschürze (1) dazu neigt, sich an die Ränder der Bodenplatte (13) anzupassen.

4. Vorrichtung (10) nach den vorhergehenden Ansprüchen, **dadurch gekennzeichnet, dass** die Schürze (1) ein Formteil (2) und einen Streifen (3) umfasst,
- wobei das Formteil (2) eine Rückseite (11) und eine Vorderseite (12) umfasst,
- wobei die Rückseite (11) an der Bodenplatte der Vorrichtung befestigt ist,
- wobei der Streifen (3) an der Vorderseite (12) befestigt ist,
- wobei das Formteil (2) dafür bestimmt ist, einen minimalem Luftdurchfluss für die Vorrichtungskühlung sicherzustellen, und
- wobei der Streifen (3) dafür bestimmt ist, Schwingungen von der Vorrichtung zu absorbieren.

5. Vorrichtung (10) nach den vorhergehenden Ansprüchen, **dadurch gekennzeichnet, dass** innerhalb der Vorrichtung ein Lüfter gegen das Entlüftungsloch angeordnet ist, um einen Luftstrom durch die Öffnung zu erzeugen.

6. Peripherieschürze (1), die dafür bestimmt ist, an einer Bodenplatte (13) einer elektronischen Vorrichtung (10) befestigt zu werden, wobei die Peripherieschürze an der Bodenplatte (13) ein Entlüftungsloch (18) umfasst, **dadurch gekennzeichnet, dass** die Schürze (1), wenn sie an der Vorrichtung (10) befestigt ist, das Loch umgibt und auf einer Seite der Bodenplatte (13) eine Öffnung für die bevorzugte Abführung von Geräusch in Richtung der Öffnung umfasst, wobei die Seite diejenige Seite ist, die von dem Benutzer am weitesten entfernt ist, wenn die Vorrichtung in ihrer Arbeitsumgebung ist.

7. Peripherieschürze (1) nach Anspruch 6, **dadurch gekennzeichnet, dass** sie ein Formteil (2), das dafür bestimmt ist, an der Vorrichtung (10) befestigt zu werden, und einen Streifen (3), der an dem Formteil (2) befestigt ist, umfasst, wobei das Formteil (2) dafür bestimmt ist, einen Raum mit einem minimalen Querschnitt zu erzeugen, wenn die Vorrichtung auf einer Oberfläche angeordnet ist, und wobei der Streifen (3) dafür bestimmt ist, Schwingungen zu absorbieren.

8. Peripherieschürze (1) nach dem vorhergehenden Anspruch, **dadurch gekennzeichnet, dass** das Formteil (2) eine Nut (9) umfasst, die dafür bestimmt ist, das Befestigen des Streifens (3) zuzulassen.

## Revendications

1. Dispositif électronique (10) comprenant un fond (13) et un orifice de ventilation (18) sur ledit fond (13), **caractérisé en ce qu'**il comprend une jupe périphérique (1) attachée audit fond (13), ladite jupe (1) entourant ledit orifice (18), ladite jupe comprenant une ouverture sur un côté dudit fond (13) pour permettre une évacuation privilégiée du bruit depuis l'orifice de ventilation vers ladite ouverture, ledit côté étant le côté le plus éloigné de l'utilisateur lorsque le dispositif se trouve dans son environnement de fonctionnement.

2. Dispositif (10) selon la revendication précédente, **caractérisé en ce que** ledit fond (13) comprend un côté arrière (17) dirigé à l'écart d'un utilisateur lorsque ledit dispositif se trouve dans des conditions de fonctionnement, et que ladite ouverture est orientée vers ledit côté arrière (17).

3. Dispositif (10) selon les revendications précédentes, **caractérisé en ce que** ladite jupe périphérique (1) a tendance à s'ajuster aux bords dudit fond (13).

4. Dispositif (10) selon les revendications précédentes, **caractérisé en ce que** ladite jupe (1) comprend une partie moulée (2) et une bande (3).
- ladite partie moulée (2) comprenant un côté arrière (11) et un côté avant (12),
- ledit côté arrière (11) étant fixé au fond dudit dispositif,
- ladite bande (3) étant fixée audit côté avant (12),
- ladite partie moulée (2) étant destinée à garantir un débit d'air minimal pour le refroidissement du dispositif, et
- ladite bande (3) étant destinée à absorber les vibrations provenant dudit dispositif.

5. Dispositif (10) selon les revendications précédentes, **caractérisé en ce qu'**un ventilateur est placé contre ledit orifice de ventilation au sein du dispositif, de sorte à créer un flux d'air via l'ouverture.

6. Jupe périphérique (1) destinée à être attachée à un fond (13) d'un dispositif électronique (10) comprenant un orifice de ventilation (18) sur ledit fond (13), **caractérisée en ce que** lorsqu'elle est fixée audit dispositif (10), ladite jupe (1) entoure ledit orifice et comprend une ouverture sur un côté dudit fond (13) pour une évacuation privilégiée du bruit vers ladite ouverture, ledit côté étant le côté le plus éloigné de l'utilisateur lorsque le dispositif se trouve dans son environnement de fonctionnement.

7. Jupe périphérique (1) selon la revendication 6, **caractérisée en ce qu'**elle comprend une partie moulée (2) destinée à être fixée audit dispositif (1) et une bande (3) fixée à ladite partie moulée (2), ladite partie moulée (2) étant destinée à créer un espace d'une section minimale lorsque le dispositif est placé sur une surface, et ladite bande (3) étant destinée à absorber les vibrations.

8. Jupe périphérique (1) selon la revendication précédente, **caractérisée en ce que** ladite partie moulée (2) comprend une fente (9) destinée à permettre la fixation de ladite bande (3).
